# EUROPEAN PATENT APPLICATION

(11) **EP 4 597 568 A1**
(43) Date of publication of application: **06.08.2025**
(21) Application number: 23869970.6
(22) Date of filing: 31.07.2023
(51) Int. Cl.: H01L 23/498, H01L 23/538, H01L 23/48, H01L 25/16, H01L 23/367, B60L 15/20

(54) **SEMICONDUCTOR POWER MODULE, MOTOR CONTROLLER AND VEHICLE**

(30) Priority: 28.09.2022 CN 202222588224 U
(71) Applicant: BYD Company Limited, Shenzhen, Guangdong 518118 (CN)
(72) Inventor: HU, Rui, Shenzhen, Guangdong 518118 (CN); LUO, Chuanming, Shenzhen, Guangdong 518118 (CN); YANG, Shengsong, Shenzhen, Guangdong 518118 (CN); GUO, Fuli, Shenzhen, Guangdong 518118 (CN)
(74) Representative: Mathys & Squire
(86) International application number: PCT/CN2023/110400
(87) International publication number: WO 2024/066724

(57) **Abstract**

A vehicle, comprising a motor controller, which comprises a semiconductor power module. The semiconductor power module comprises a substrate, a first power chip, a second power chip, a third power chip, and, arranged spaced apart on the substrate, a first conductive region, a second conductive region, a third conductive region, and a fourth conductive region. The first and second conductive regions are disposed on two opposite sides of the third conductive region, and the fourth conductive region is disposed between the first and third conductive regions and between the second and third conductive regions. The first power chip is installed in the first conductive region and connected to the third conductive region, the second power chip is installed in the second conductive region and connected to the third conductive region, and the third power chip is installed in the third conductive region and connected to the fourth conductive region.

## Description

### CROSS-REFERENCE TO RELATED APPLICATIONS

The present disclosure claims priority to and benefits of Chinese Patent Application No. 202222588224.1, filed on September 28, 2022 and entitled "SEMICONDUCTOR POWER MODULE, MOTOR CONTROLLER, AND VEHICLE". The entire content of the above-referenced application is incorporated herein by reference.

### FIELD

The present disclosure relates to the field of semiconductor technologies, and in particular, to a semiconductor power module, a motor controller, and a vehicle.

### BACKGROUND

Power modules have characteristics such as a high switching speed, a high AC-DC conversion frequency, and a high overcurrent. The power module is an important switching component in a control system. For example, in a whole vehicle control system, a switching loss and an on-state loss are generated in frequent switching engineering. During use, if there is a large stray inductance in the power module or a poor heat dissipation capability of the power module, a large quantity of losses are generated during application, which not only increases unnecessary power consumption, but also causes a risk of burning out a module chip, resulting in a module failure, and further causing a serious control failure problem.

### SUMMARY

The present disclosure aims to resolve at least one of the technical problems in the prior art. Therefore, an objective of the present disclosure is to provide a semiconductor power module, the semiconductor power module having advantages such as a small stray inductance, good heat dissipation performance, and a high power density.

The present disclosure further provides a motor controller having the foregoing semiconductor power module.

The present disclosure further provides a vehicle having the foregoing motor controller.

To achieve the foregoing objective, an embodiment according to a first aspect of the present disclosure provides a semiconductor power module, including: a substrate; a first conductive region, a second conductive region, a third conductive region, and a fourth conductive region being arranged spaced apart on the substrate, the first conductive region and the second conductive region being respectively arranged on two opposite sides of the third conductive region, the fourth conductive region having a part disposed between the first conductive region and the third conductive region, and the fourth conductive region further having with a part disposed between the second conductive region and the third conductive region, the first conductive region, the second conductive region, and the fourth conductive region being configured to transmit DC signals, and the third conductive region being configured to transmit AC signals; at least one first power chip, the first power chip being mounted in the first conductive region, and the first power chip being connected to the third conductive region; at least one second power chip, the second power chip being mounted in the second conductive region, and the second power chip being connected to the third conductive region; and at least one third power chip, the third power chip being mounted in the third conductive region, and the third power chip being connected to the fourth conductive region; and the first power chip and the third power chip being separated by the fourth conductive region, and the second power chip and the third power chip being separated by the fourth conductive region.

The semiconductor power module according to this embodiment of the present disclosure has advantages such as a small stray inductance, good heat dissipation performance, and a high power density.

According to some embodiments of the present disclosure, the substrate includes a first direction and a second direction orthogonal to each other. The first conductive region and the second conductive region extend in the second direction, the first conductive region and the second conductive region are respectively arranged on two opposite sides of the third conductive region in the first direction, a part of the fourth conductive region is disposed between the first conductive region and the third conductive region in the first direction, and a part of the fourth conductive region is further disposed between the second conductive region and the third conductive region in the first direction. The first power chip and the third power chip are separated in the first direction by the fourth conductive region, and the second power chip and the third power chip are separated in the first direction by the fourth conductive region.

According to some embodiments of the present disclosure, the fourth conductive region is around at least a part of the third conductive region and has an open-loop shape.

According to some embodiments of the present disclosure, the fourth conductive region includes: a first vertical section, a first transverse section, and a second transverse section. The first vertical section extends in the first direction, and the first vertical section is located at an end of the third conductive region in the second direction. The first transverse section extends in the second direction, the first transverse section is connected to the first vertical section, the first transverse section is located between the first conductive region and the third conductive region in the first direction, the first power chip and the third power chip are separated by the first transverse section in the first direction, and the first transverse section is connected to the third power chip. The second transverse section extends in the second direction, the second transverse section is connected to the first vertical section, the second transverse section is located between the second conductive region and the third conductive region in the first direction, the second power chip and the third power chip are separated by the second transverse section in the first direction, and the second transverse section is connected to the third power chip.

According to some embodiments of the present disclosure, the first power chip is connected to the third conductive region by a first connection member, the second power chip is connected to the third conductive region by a second connection member, and the third power chip is connected to the fourth conductive region by a third connection member; and the first connection member, the second connection member, and the third connection member extend in the first direction.

According to some embodiments of the present disclosure, the semiconductor power module includes a fifth conductive region. The third conductive region includes an opening, a plurality of third power chips, the plurality of third power chips being respectively arranged on two opposite sides of the opening, the fifth conductive region being arranged on the substrate, the fifth conductive region being located in the opening, the fifth conductive region being arranged spaced apart from the third conductive region, and the fifth conductive region being connected to the plurality of third power chips; and the fifth conductive region being configured to transmit control signals.

According to some embodiments of the present disclosure, the substrate includes a first direction and a second direction orthogonal to each other; and the opening and the fifth conductive region both extend in the second direction, and the plurality of third power chips are respectively arranged on two opposite sides of the opening in the first direction.

According to some embodiments of the present disclosure, the third conductive region includes: a third transverse section and a fourth transverse section, the third transverse section and the fourth transverse section both extending in the second direction, the opening being located between the third transverse section and the fourth transverse section, the plurality of third power chips being respectively mounted on the third transverse section and the fourth transverse section, the third transverse section being connected to the first power chip, and the fourth transverse section being connected to the second power chip; and a second vertical section, the second vertical section extending in the first direction, the second vertical section being connected to an end of the third transverse section that faces away from the fourth conductive region, and the second vertical section being connected to an end of the fourth transverse section that faces away from the fourth conductive region.

According to some embodiments of the present disclosure, two ends of the second vertical section respectively extend beyond the fourth conductive region in the first direction.

According to some embodiments of the present disclosure, a plurality of first resistors are arranged in the fifth conductive region, and the plurality of third power chips are connected to the plurality of first resistors in a one-to-one correspondence.

According to some embodiments of the present disclosure, the semiconductor power module includes: an AC signal terminal, the AC signal terminal being mounted in the third conductive region and configured to obtain electrical signals of the third conductive region; a first DC transmission signal terminal, the first DC transmission signal terminal being mounted in at least one of the first conductive region and the second conductive region, and configured to obtain electrical signals of the at least one of the first conductive region or the second conductive region; a second DC transmission signal terminal, the second DC transmission signal terminal being mounted in the fourth conductive region and configured to obtain electrical signals of the fourth conductive region; and a control signal terminal, the control signal terminal being mounted in the fifth conductive region and configured to control the fifth conductive region to transmit the control signals.

According to some embodiments of the present disclosure, the third power chip includes a third power region and a third control region, the third power region is connected to the fourth conductive region, and the third control region is connected to the fifth conductive region.

According to some embodiments of the present disclosure, the semiconductor power module includes: a sixth conductive region, the sixth conductive region being arranged on the substrate, the substrate including a first direction and a second direction orthogonal to each other, the sixth conductive region being located on a side of the first conductive region in the second direction, the sixth conductive region being arranged spaced apart from the first conductive region, the sixth conductive region being located on a side of the third conductive region in the first direction, and the sixth conductive region being arranged spaced apart from the third conductive region; and a temperature sensor, the temperature sensor being mounted in the sixth conductive region.

According to some embodiments of the present disclosure, the semiconductor power module includes: a seventh conductive region, the seventh conductive region being arranged on the substrate, the seventh conductive region being located on a side of the first conductive region that faces away from the fourth conductive region, and the first power chip being connected to the seventh conductive region; and an eighth conductive region, the eighth conductive region being arranged on the substrate, the eighth conductive region being located on a side of the second conductive region that faces away from the fourth conductive region, and the second power chip being connected to the eighth conductive region; where the seventh conductive region and the eighth conductive region are configured to transmit control signals.

According to some embodiments of the present disclosure, a plurality of second resistors are arranged in the seventh conductive region, a plurality of first power chips are included, and the plurality of first power chips are connected to the plurality of second resistors in a one-to-one correspondence A plurality of third resistors are arranged in the eighth conductive region, a plurality of second power chips are included, and the plurality of second power chips are connected to the plurality of third resistors in a one-to-one correspondence.

According to some embodiments of the present disclosure, the first power chip includes a first power region and a first control region, the first power region is connected to the third conductive region, and the first control region is connected to the seventh conductive region. The second power chip includes a second power region and a second control region, the second power region is connected to the third conductive region, and the second control region is connected to the eighth conductive region.

According to some embodiments of the present disclosure, the semiconductor power module includes: a first DC transmission terminal, the first DC transmission terminal being connected to the fourth conductive region, and the first DC transmission terminal extending beyond an edge of the substrate; a second DC transmission terminal, the second DC transmission terminal being connected to the first conductive region, and the second DC transmission terminal extending beyond the edge of the substrate; a third DC transmission terminal, the third DC transmission terminal being connected to the second conductive region, and the third DC transmission terminal extending beyond the edge of the substrate; and an AC transmission terminal, the AC transmission terminal being connected to the third conductive region, and the AC transmission terminal extending beyond the edge of the substrate. The first DC transmission terminal, the second DC transmission terminal, and the third DC transmission terminal are arranged on one of the two opposite sides of the substrate, and the AC transmission terminal is arranged on the other of the two opposite sides of the substrate.

According to some embodiments of the present disclosure, a first high-voltage connection part is disposed in the first conductive region, a width of the first high-voltage connection part is greater than a width of a remaining part of the first conductive region, and the second DC transmission terminal is connected to the first high-voltage connection part. The second conductive region has a second high-voltage connection part, a width of the second high-voltage connection part is greater than a width of a remaining part of the second conductive region, and the third DC transmission terminal is connected to the second high-voltage connection part.

According to some embodiments of the present disclosure, the second DC transmission terminal and the third DC transmission terminal are formed as a whole, and the second DC transmission terminal and the third DC transmission terminal are spaced apart from and overlap with the first DC transmission terminal in a thickness direction of the substrate.

According to some embodiments of the present disclosure, the substrate includes: an insulation layer; a circuit layer, the circuit layer being connected to a side of the insulation layer in a thickness direction of the insulation layer, and the first conductive region, the second conductive region, the third conductive region, and the fourth conductive region being formed on the circuit layer; and a heat dissipation layer, the heat dissipation layer being connected to another side of the insulation layer in the thickness direction of the insulation layer.

According to some embodiments of the present disclosure, the semiconductor power module includes: an insulation cover. The insulation cover is mounted on the substrate and covers the first conductive region, the second conductive region, the third conductive region, the fourth conductive region, the first power chip, the second power chip, and the third power chip.

According to an embodiment of a second aspect of the present disclosure, a motor controller is provided, including: a heat dissipation bottom plate and a coolant channel, the heat dissipation bottom plate being mounted in the coolant channel; and the semiconductor power module according to the embodiment of the first aspect of the present disclosure, the semiconductor power module being arranged on the heat dissipation bottom plate.

According to the embodiment of the second aspect of the present disclosure, by using the semiconductor power module according to the embodiment of the first aspect of the present disclosure, the motor controller has advantages such as a small stray inductance, good heat dissipation performance, and a high power density.

According to some embodiments of the present disclosure, a plurality of semiconductor power modules are included, and the plurality of semiconductor power modules are arranged spaced apart on the heat dissipation bottom plate.

According to an embodiment of a third aspect of the present disclosure, a vehicle is proposed, including: a motor; and the motor controller according to the embodiment of the second aspect of the present disclosure, the motor controller being connected to the motor.

According to the embodiment of the third aspect of the present disclosure, by using the motor controller according to the embodiment of the second aspect of the present disclosure, the vehicle has advantages such as a small stray inductance, good heat dissipation performance, and a high power density.

Additional aspects and advantages of the present disclosure will be given in the following descriptions, some of which will become apparent from the following descriptions or may be learned from practices of the present disclosure.

### BRIEF DESCRIPTION OF THE DRAWINGS

The foregoing and/or additional aspects and advantages of the present disclosure will become apparent and comprehensible in the descriptions of the embodiments made with reference to the following accompanying drawings.
FIG. 1 is a schematic structural diagram of a semiconductor power module according to an embodiment of the present disclosure;
FIG. 2 is a schematic structural diagram of a semiconductor power module according to another embodiment of the present disclosure;
FIG. 3 is a schematic structural diagram of a semiconductor power module from another perspective according to another embodiment of the present disclosure;
FIG. 4 is a schematic structural diagram of a semiconductor power module according to another embodiment of the present disclosure;
FIG. 5 is a partial schematic structural diagram of a semiconductor power module according to an embodiment of the present disclosure;
FIG. 6 is a partial schematic structural diagram of a semiconductor power module from another perspective according to an embodiment of the present disclosure;
FIG. 7 is a partial schematic structural diagram of a semiconductor power module from another perspective according to an embodiment of the present disclosure;
FIG. 8 is a partial schematic structural diagram of a motor controller according to an embodiment of the present disclosure; and
FIG. 9 is a schematic block diagram of a vehicle according to an embodiment of the present disclosure.

In the drawings:
Semiconductor power module 1, motor controller 2,
substrate 100, insulation layer 101, circuit layer 102, heat dissipation layer 103,
first conductive region 110, first high-voltage connection part 111,
second conductive region 120, second high-voltage connection part 121,
third conductive region 130, second vertical section 131, third transverse section 132, fourth transverse section 133,
fourth conductive region 140, first vertical section 141, first transverse section 142, second vertical section 143,
fifth conductive region 150, opening 151, first resistor 152,
sixth conductive region 160, temperature sensor 161,
seventh conductive region 170, second resistor 171,
eighth conductive region 180, third resistor 181, ninth conductive region 190,
first power chip 200, first power region 2001, first control region 2002, first connection member 210,
second power chip 300, second power region 3001, second control region 3002, second connection member 310,
third power chip 400, third power region 4001, third control region 4002, third connection member 430, vehicle 1000, motor 1001,
first DC transmission terminal 500, second DC transmission terminal 510, third DC transmission terminal 520, AC transmission terminal 530, AC signal terminal 540, first DC transmission signal terminal 550, control signal terminal 560, temperature signal terminal 570, second DC transmission signal terminal 580,
heat dissipation bottom plate 700, insulation layer cover 800, coolant channel 900,
first direction A, and second direction B.

### DETAILED DESCRIPTION

The embodiments described with reference to accompanying drawings are exemplary, and the embodiments of the present disclosure are described in detail below.

In the descriptions of the present disclosure, it should be understood that orientation or position relationships indicated by the terms such as "center", "longitudinal", "transverse", "length", "width", "thickness", "on", "below", "front", "back", "left", "right", "vertical", "horizontal", "top", "bottom", "inside", "outside", "clockwise", "counterclockwise", "axial direction", "radial direction", and "circumferential direction" are based on orientation or position relationships shown in the accompanying drawings, and are used only for ease and brevity of illustration and description, rather than indicating or implying that the mentioned apparatus or component must have a particular orientation or must be disposed and operated in a particular orientation.

In the descriptions of the disclosure, "a plurality of" means two or more.

A semiconductor power module 1 according to the embodiments of the disclosure is described below with reference to the accompanying drawings.

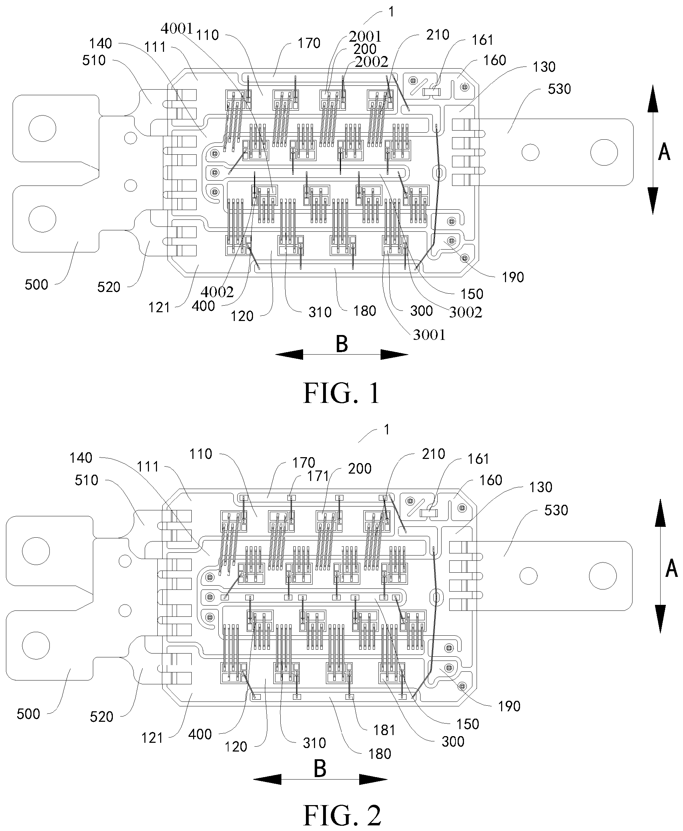

In FIG. 1 to FIG. 8, the semiconductor power module 1 according to the embodiments of the present disclosure includes a substrate 100, a first power chip 200, a second power chip 300, and a third power chip 400.

The semiconductor power module 1 further includes a first conductive region 110, a second conductive region 120, a third conductive region 130, and a fourth conductive region 140 arranged spaced apart on the substrate 100. The first conductive region 110 and the second conductive region 120 are respectively arranged on two opposite sides of the third conductive region 130. At least a part of the fourth conductive region 140 is arranged between the first conductive region 110 and the third conductive region 130 and between the second conductive region 120 and the third conductive region 130. The first conductive region 110, the second conductive region 120, and the fourth conductive region 140 are configured to transmit DC signals, and the third conductive region 130 is configured to transmit AC signals. The first power chip 200 is mounted in the first conductive region 110 and connected to the third conductive region 130, the second power chip 300 is mounted in second conductive region 120 and connected to the third conductive region 130, and the third power chip 400 is mounted in the third conductive region 130 and connected to the fourth conductive region 140. The first power chip 200 and the third power chip 400 are separated by the fourth conductive region 140, and the second power chip 300 and the third power chip 400 are separated by the fourth conductive region 140.

For example, the first power chip 200 may include, but is not limited to, a silicon carbide MOSFET chip, an IGBT chip, a reverse conducting IGBT chip, and a power diode chip; the second power chip 300 may include, but is not limited to, a silicon carbide MOSFET chip, an IGBT chip, a reverse conducting IGBT chip, and a power diode chip; and the third power chip 400 may include, but is not limited to, a silicon carbide MOSFET chip, an IGBT chip, a reverse conducting IGBT chip, and a power diode chip.

In addition, the first power chip 200 is electrically connected to the first conductive region 110 through a welding process or a sintering process, the second power chip 300 is electrically connected to the second conductive region 120 through a welding process or a sintering process, and the third power chip 400 is electrically connected to the third conductive region 130 through a welding process or a sintering process.

According to the semiconductor power module 1 in this embodiment of the present disclosure, the first conductive region 110 and the second conductive region 120 are arranged on the substrate 100, the first conductive region 110 and the second conductive region 120 are respectively arranged on two opposite sides of the third conductive region 130; the first conductive region 110, the second conductive region 120, and the fourth conductive region 140 are configured to transmit DC signals, and the third conductive region 130 is configured to transmit AC signals. The first conductive region 110 and the second conductive region 120 may be configured to output the DC signals, the fourth conductive region 140 is configured to input the DC signals, and the third conductive region 130 is configured to transmit the AC signals. The first power chip 200 is mounted in the first conductive region 110 and is connected to the third conductive region 130, and the second power chip 300 is mounted in the second conductive region 120 and is connected to the third conductive region 130.

In this way, the semiconductor power module 1 can implement DC-AC conversion , and self-inductances between the first conductive region 110 together with the second conductive region 120 and the fourth conductive region 140 can cancel each other out. Because a distance between the first conductive region 110 together with the second conductive region 120 and the fourth conductive region 140 is closer, a parasitic inductance of the semiconductor power module 1 is more effectively reduced, and a switching loss is reduced.

In addition, at least a part of the fourth conductive region 140 is arranged between the first conductive region 110 and the third conductive region 130 and between the second conductive region 120 and the third conductive region 130, and the third power chip 400 is mounted in the third conductive region 130 and is connected to the fourth conductive region 140. In addition, the first power chip 200 and the third power chip 400 are separated by the fourth conductive region 140, and the second power chip 300 and the third power chip 400 are separated by the fourth conductive region 140.

Therefore, the fourth conductive region 140 not only can separate the first conductive region 110 from the third conductive region 130, but also can separate the second conductive region 120 from the third conductive region 130, separate the first power chip 200 from the third power chip 400, and separate the second power chip 300 from the third power chip 400. On the basis of ensuring that a stray inductance does not increase, space utilization of the substrate 100 is improved, distances between the first power chip 200, the second power chip 300, and the third power chip 400 are increased, thereby greatly improving heat dissipation performance of the semiconductor power module 1. The semiconductor power module 1 has a low stray inductance and good heat dissipation performance. In a case in which an area of the substrate 100 is not increased, and the stray inductance and the heat dissipation performance are not affected, an overall quantity of the first power chips 200, the second power chips 300, and the third power chips 400 may be increased, thereby greatly increasing a power density of the semiconductor power module 1.

In addition, because the first conductive region 110 and the second conductive region 120 are closer to the fourth conductive region 140, a length of a current path is shorter, and a width of the current path is larger, thereby further greatly reducing the stray inductance in the semiconductor power module 1.

In this way, the semiconductor power module 1 according to this embodiment of the present disclosure has advantages such as a small stray inductance and a good heat dissipation effect.

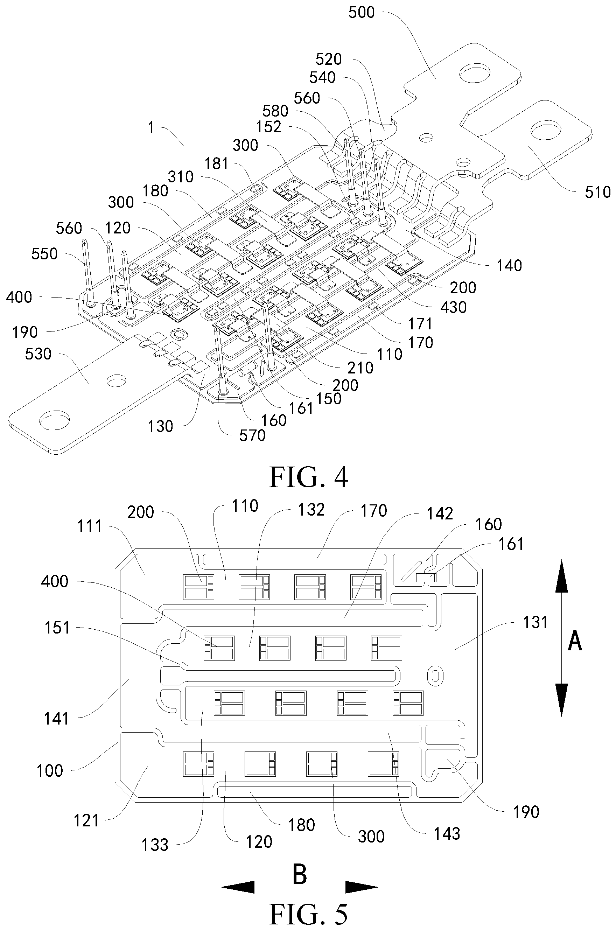

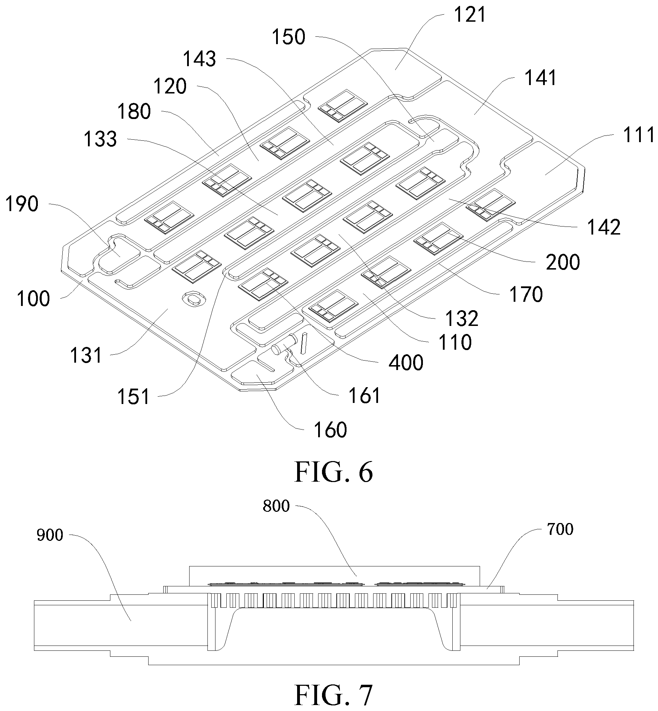

According to some specific embodiments of the present disclosure, in FIG. 5 and FIG. 6, the substrate 100 has a first direction and a second direction orthogonal to each other. The first conductive region 110 and the second conductive region 120 extend along the second direction, the first conductive region 110 and the second conductive region 120 are respectively arranged on two opposite sides of the third conductive region 130 in the first direction. At least a part of the fourth conductive region 140 is arranged between the first conductive region 110 and the third conductive region 130 and between the second conductive region 120 and the third conductive region 130 in the first direction. The first power chip 200 and the third power chip 400 are separated in the first direction by the fourth conductive region 140, and the second power chip 300 and the third power chip 400 are separated in the first direction by the fourth conductive region 140.

In other words, the fourth conductive region 140 separates the first conductive region 110 and the third conductive region 130 in the first direction, and the fourth conductive region 140 separates the second conductive region 120 and the third conductive region 130 in the first direction. The first conductive region 110, the second conductive region 120, the third conductive region 130, and the fourth conductive region 140 may extend in the second direction, and the first conductive region 110, the second conductive region 120, the third conductive region 130, and the fourth conductive region 140 may be arranged spaced apart in the first direction, so that the first conductive region 110, the second conductive region 120, the third conductive region 130, and the fourth conductive region 140 may fully utilize space on the substrate 100, and overall space occupied by the first conductive region 110, the second conductive region 120, the third conductive region 130, and the fourth conductive region 140 is not excessively large. Therefore, miniaturization of the semiconductor power module 1 is facilitated.

According to some specific embodiments of the present disclosure, in FIG. 5 and FIG. 6, the fourth conductive region 140 is around at least a part of the third conductive region 130 and has an open-loop shape. In this way, self-inductances of the first conductive region 110 and the second conductive region 120 can better cancel a self-inductance of the fourth conductive region 140 out, thereby reducing a parasitic inductance of the semiconductor power module 1 and reducing a switching loss.

According to some specific embodiments of the present disclosure, in FIG. 5, the fourth conductive region 140 includes a first vertical section 141, a second transverse section 142, and a second transverse section 143.

The first vertical section 141 extends along the first direction and is located on a side of the third conductive region 130 in the second direction. The first transverse section 142 and the second transverse section 143 extend along the second direction and are both connected to the first vertical section 141. The first transverse section 142 is located between the first conductive region 110 and the third conductive region 130 in the first direction. The first power chip 200 and the third power chip 400 are separated by the first transverse section 142 in the first direction. The second transverse section 143 is located between the second conductive region 120 and the third conductive region 130 in the first direction. The second power chip 300 and the third power chip 400 are separated by the second transverse section 143 in the first direction. The first transverse section 142 and the second transverse section 143 are connected to the third power chip 400.

The first transverse section 142 is arranged to separate, in the first direction, the first conductive region 110 from the third conductive region 130 and the first power chip 200 from the third power chip 400, and the second transverse section 143 is arranged to separate, in the first direction, the second conductive region 120 from the third conductive region 130 and the second power chip 300 from the third power chip 400.

In addition, the first transverse section 142, the second transverse section 143, the first conductive region 110, the second conductive region 120, and the third conductive region 130 may be parallel to each other, to reduce space occupied by the first conductive region 110, the second conductive region 120, the third conductive region 130, and the fourth conductive region 140, and improve space utilization of the substrate 100. The first vertical section 141 may be connected to the first transverse section 142 and the second transverse section 143, so that a series structure is formed between the first vertical section 141, the first transverse section 142, and the second transverse section 143.

According to some specific embodiments of the present disclosure, as shown in FIG. 1 to FIG. 4, the first power chip 200 is connected to the third conductive region 130 by a first connection member 210, the second power chip 300 is connected to the third conductive region 130 by a second connection member 310, and the third power chip 400 is connected to the fourth conductive region 140 by a third connection member 430. The first connection member 210, the second connection member 310, and the third connection member 430 extend in the first direction.

For example, the first connection member 210 may be an aluminum wire, a copper wire, a gold wire, a copper strip, an aluminum strip, a copper connecting piece, or the like, the second connection member 310 may be an aluminum wire, a copper wire, a gold wire, a copper strip, an aluminum strip, a copper connecting piece, or the like, and the third connection member 430 may be an aluminum wire, a copper wire, a gold wire, a copper strip, an aluminum strip, a copper connecting piece, or the like. The first connection member 210 may be perpendicular to the first transverse section 142 and the first conductive region 110, the second connection member 310 may be perpendicular to the second transverse section 143 and the second conductive region 120, and the third connection member 430 may be perpendicular to the third conductive region 130 and the fourth conductive region 140. In this way, lengths of the first connection member 210, the second connection member 310, and the third connection member 430 can be set to be shorter, thereby reducing stray inductances generated on the first connection member 210, the second connection member 310, and the third connection member 430, reducing production costs, and making it easier to arrange circuits.

According to some specific embodiments of the present disclosure, in FIG. 5 and FIG. 6, the semiconductor power module 1 further includes a fifth conductive region 150.

The third conductive region 130 has an opening 151 A plurality of third power chips 400 are arranged on two opposite sides of the opening 151. The fifth conductive region 150 is arranged on the substrate 100 and located in the opening 151. The fifth conductive region 150 is arranged spaced apart from the third conductive region 130 and is connected to the third power chip 400. The fifth conductive region 150 is configured to transmit control signals.

The fifth conductive region 150 may transmit control signals to control on/off of the third power chip 400, so as to control AC-DC conversion of the semiconductor power module 1, thereby ensuring normal operation of the semiconductor power module 1.

According to some specific embodiments of the present disclosure, as shown in FIG. 1 to FIG. 6, the substrate 100 has the first direction and the second direction orthogonal to each other, the opening 151 and the fifth conductive region 150 extend in the second direction, and the third power chip 400 is respectively arranged on two opposite sides of the opening 151 in the first direction.

In this way, the plurality of third power chips 400 are separated by the opening 151 in the first direction, thereby preventing heat accumulation, improving a heat dissipation capability of the fifth conductive region 150, and improving a heat dissipation capability of the semiconductor power module 1 correspondingly.

According to some specific embodiments of the present disclosure, as shown in FIG. 5 and FIG. 6, the third conductive region 130 includes a second vertical section 131, a third transverse section 132, and a fourth transverse section 133.

The third transverse section 132 and the fourth transverse section 133 extend in the second direction, the opening 151 is located between the third transverse section 132 and the fourth transverse section 133, the third power chip 400 is respectively mounted on the third transverse section 132 and the fourth transverse section 133, the third transverse section 132 is connected to the first power chip 200, the fourth transverse section 133 is connected to the second power chip 300, the second vertical section 131 extends in the first direction, and the second vertical section 131 is connected to an end of the third transverse section 132 that faces away from the fourth conductive region 140 and an end of the fourth transverse section 133 that faces away from the fourth conductive region 140.

The first transverse section 142 and the second transverse section 143 may be configured to arrange the third power chip 400. An end of the first transverse section 142 close to the second vertical section 131 may be connected to an end of the second transverse section 143 close to the second vertical section 131, so that the plurality of third power chips 400 are connected in parallel. The second vertical section 131 may be configured to be connected to an AC transmission terminal 530 described below, thereby avoiding interference between the AC transmission terminal 530 and the plurality of third power chips 400, and ensuring reliability of electrical connection.

According to some specific embodiments of the present disclosure, as shown in FIG. 5 and FIG. 6, two ends of the second vertical section 131 respectively extend beyond the fourth conductive region 140 in the first direction. A size of the second vertical section 131 in the first direction is larger. The AC transmission terminal 530 described below may be connected to the second vertical section 131, so that a contact area between the AC transmission terminal 530 and the third conductive region 130 is increased, thereby ensuring reliability of electrical connection between the AC transmission terminal 530 and the third conductive region 130.

According to some specific embodiments of the present disclosure, as shown in FIG. 5 and FIG. 6, a plurality of first power chips 200 are arranged spaced apart in the second direction, a plurality of third power chips 400 on the third transverse section 132 are arranged spaced apart in the second direction, and the plurality of first power chips 200 and the plurality of third power chips 400 on the third transverse section 132 are arranged alternately in the second direction.

In addition, a plurality of second power chips 300 are arranged spaced apart in the second direction, a plurality of third power chips 400 on the fourth transverse section 133 are arranged spaced apart in the second direction, and the plurality of second power chips 300 and the plurality of third power chips 400 on the fourth transverse section 133 are alternately arranged in the second direction.

In addition, the plurality of third power chips 400 on the third transverse section 132 and the plurality of third power chips 400 on the fourth transverse section 133 may alternatively be alternately arranged in the second direction.

In this way, the first power chips 200, the second power chips 300, and the third power chips 400 are distributed more evenly in the first direction, and the first power chips 200, the second power chips 300, and the third power chips 400 are distributed alternately between two adjacent rows in the second direction, so as to further reduce a probability of local heat accumulation of the semiconductor power module 1, thereby improving a heat dissipation capability of the semiconductor power module 1.

According to some specific embodiments of the present disclosure, as shown in FIG. 1 and FIG. 4, a plurality of first resistors 152 are arranged in the fifth conductive region 150, and the plurality of third power chips 400 are connected to the plurality of first resistors 152 in a one-to-one correspondence. The first resistor 152 may be a gate resistor, and the first resistor 152 and the third power chip 400 may be connected through an aluminum wire, a copper wire, a gold wire, a copper strip, an aluminum strip, a copper connecting piece, or the like.

Because parameters of the plurality of third power chips 400 may be uneven, by arranging the plurality of first resistors 152, differences between the plurality of third power chips 400 can be reduced, and performance of the semiconductor power module 1 can be improved.

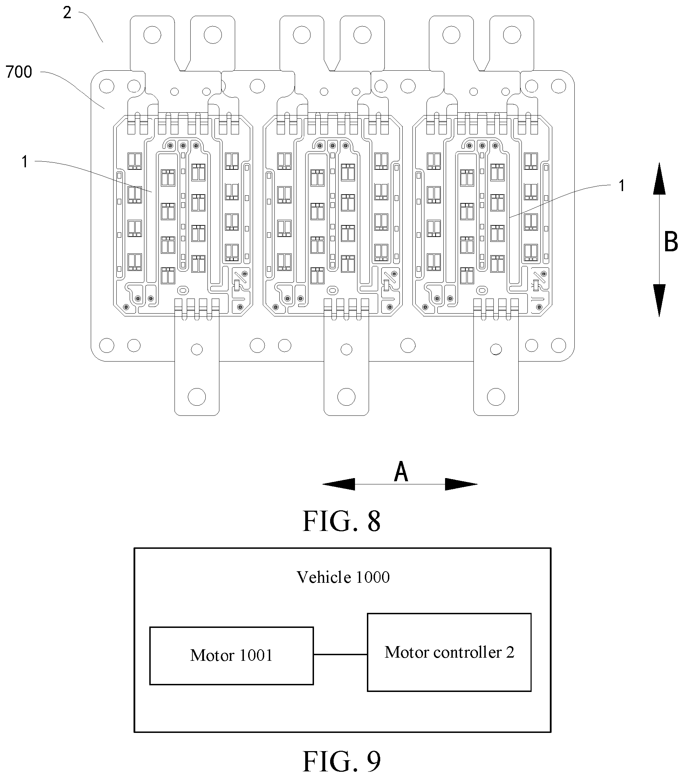

According to some specific embodiments of the present disclosure, as shown in FIG. 1 and FIG. 8, the third power chip 400 has a third power region 4001 and a third control region 4002, the third power region 4001 is connected to the fourth conductive region 140, and the third control region 4002 is connected to the fifth conductive region 150. For example, when the first resistors 152 are arranged in the fifth conductive region 150, the third control regions 4002 of the third power chips 400 are connected to the first resistors 152 in a one-to-one correspondence, so that the third control region 4002 of the third power chip 400 is connected to the fifth conductive region 150.

The fifth conductive region 150 transmits different control electrical signals to the third control region 4002, so as to control on/off of the third power chip 400, thereby controlling whether the third conductive region 130 is connected to the fourth conductive region 140 through the third power region 4001. In this way, a current direction of the semiconductor power module 1 can be controlled, so that the semiconductor power module 1 can implement conversion between AC and DC.

According to some specific embodiments of the present disclosure, as shown in FIG. 1 to FIG. 6, the semiconductor power module 1 further includes a sixth conductive region 160 and a temperature sensor 161.

The sixth conductive region 160 is arranged on the substrate 100. The substrate 100 has the first direction and the second direction orthogonal to each other. The sixth conductive region 160 is located on a side of the first conductive region 110 in the second direction and is arranged spaced apart from the first conductive region 110. The sixth conductive region 160 is located on a side of the third conductive region 130 in the first direction and is arranged spaced apart from the third conductive region 130. The temperature sensor 161 is mounted in the sixth conductive region 160.

By arranging the sixth conductive region 160, electricity can be supplied to the temperature sensor 161, so that the temperature sensor 161 can detect a temperature of the substrate 100, to indirectly detect a temperature of a power chip of the semiconductor power module 1, thereby preventing the temperature of the power chip from being excessively high and causing damage.

According to some specific embodiments of the present disclosure, as shown in FIG. 1 to FIG. 6, the semiconductor power module 1 further includes a seventh conductive region 170 and an eighth conductive region 180.

The seventh conductive region 170 is arranged on the substrate 100 and located on a side of the first conductive region 110 that faces away from the fourth conductive region 140. The first power chip 200 is connected to the seventh conductive region 170. The eighth conductive region 180 is arranged on the substrate 100 and located on a side of the second conductive region 120 that faces away from the fourth conductive region 140. The second power chip 300 is connected to the eighth conductive region 180. The seventh conductive region 170 and the eighth conductive region 180 are configured to transmit control signals.

When a plurality of semiconductor power modules 1 are arranged spaced apart in the first direction, the seventh conductive regions 170 and the eighth conductive regions 180 of the two adjacent semiconductor power modules 1 may cause the first power chip 200 in the first conductive region 110 and the second power chip 300 in the second conductive region 120 of the two adjacent semiconductor power modules 1 to be spaced apart, to ensure that distances between the first power chips 200, the second power chips 300, and the third power chips 400 of the plurality of semiconductor power modules 1 remain as uniform as possible, thereby improving cooling efficiency of the first power chip 200, the second power chip 300, and the third power chip 400 of each semiconductor power module 1, and improving heat dissipation performance of the plurality of semiconductor power modules 1.

On the basis of ensuring that a stray inductance does not increase, utilization space of the substrate 100 is saved, and the distances between the first power chip 200, the second power chip 300, and the third power chip 400 are increased, thereby greatly improving the heat dissipation performance of the semiconductor power module 1.

Integrating the advantages of the semiconductor power module 1 such as low stray inductance and good heat dissipation performance, in a case in which an area of the substrate 100 is not increased, and the stray inductance and the heat dissipation performance are not affected, an overall quantity of the first power chips 200, the second power chips 300, and the third power chips 400 is increased, thereby greatly increasing a power density of the semiconductor power module 1.

According to some specific embodiments of the present disclosure, as shown in FIG. 1 and FIG. 4, a plurality of second resistors 171 are arranged in the seventh conductive region 170, a plurality of first power chips 200 are connected to the plurality of second resistors 171 in a one-to-one correspondence; a plurality of third resistors 181 are arranged in the eighth conductive region 180, and a plurality of second power chips 300 are connected to the plurality of third resistors 181 in a one-to-one correspondence.

The second resistor 171 and the third resistor 181 may be gate resistors. The second resistor 171 may be connected to the first power chip 200 through an aluminum wire, a copper wire, a gold wire, a copper strip, an aluminum strip, a copper connecting piece, or the like, and the third resistor 181 may be connected to the second power chip 300 through an aluminum wire, a copper wire, a gold wire, a copper strip, an aluminum strip, a copper connecting piece, or the like. Because parameters of the plurality of first power chips 200 and the plurality of second power chips 300 may be uneven, by arranging the plurality of second resistors 171 and the plurality of third resistors 181, differences between the plurality of first power chips 200 and the plurality of second power chips 300 can be reduced, and performance of the semiconductor power module 1 can be improved.

According to some specific embodiments of the present disclosure, as shown in FIG. 1, the first power chip 200 has a first power region 2001 and a first control region 2002, the first power region 2001 is connected to the third conductive region 130, and the first control region 2002 is connected to the seventh conductive region 170. The second power chip 300 has a second power region 3001 and a second control region 3002. The second power region 3001 is connected to the third conductive region 130, and the second control region 3002 is connected to the eighth conductive region 180.

For example, when the second resistors 171 are arranged in the seventh conductive region 170, first control regions 2002 of the first power chips 200 are connected to the second resistors 171 in a one-to-one correspondence, so that the first control region 2002 of the first power chip 200 is connected to the seventh conductive region 170; when the third resistors 181 are arranged in the eighth conductive region 180, second control regions 3002 of the second power chips 300 are connected to the third resistors 181 in a one-to-one correspondence, so that the second control region 3002 of the second power chip 300 is connected to the eighth conductive region 180.

The seventh conductive region 170 transmits different control signals to the first control region 2002, to control on/off of the first power chip 200, thereby controlling whether the first conductive region 110 is connected to the third conductive region 130 through the first power region 2001; the eighth conductive region 180 transmits different control signals to the second control region 3002, to control on/off of the second power chip 300, thereby controlling whether the second conductive region 120 is connected to the third conductive region 130 through the second power region 3001. In this way, a current direction of the semiconductor power module 1 can be controlled, so that the semiconductor power module 1 can implement conversion between AC and DC.

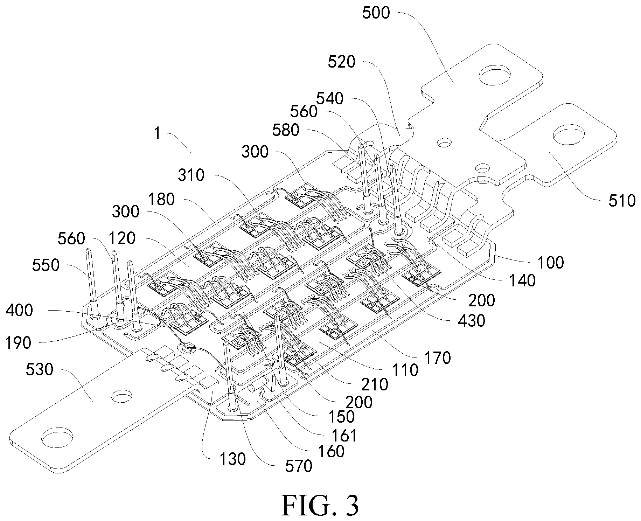

According to some specific embodiments of the present disclosure, as shown in FIG. 3 to FIG. 4, the semiconductor power module 1 further includes an AC signal terminal 540, a first DC transmission signal terminal 550, a control signal terminal 560, a temperature signal terminal 570, and a second DC transmission signal terminal 580.

The AC signal terminal 540 is mounted in the third conductive region 130 and is configured to obtain electrical signals of the third conductive region 130. The first DC transmission signal terminal 550 is mounted in at least one of the first conductive region 110 or the second conductive region 120, and is configured to obtain electrical signals of the at least one of the first conductive region 110 or the second conductive region 120. The second DC transmission signal terminal 580 is mounted in the fourth conductive region 140 and is configured to obtain electrical signals of the fourth conductive region 140. The control signal terminal 560 is mounted in the fifth conductive region 150 and is configured to control the fifth conductive region 150 to transmit control signals. The temperature signal terminal 570 is mounted in the sixth conductive region 160, and is configured to obtain electrical signals of the temperature sensor 161.

In this way, DC signals, AC signals, and temperature electrical signals of the semiconductor power module 1 can be obtained through the AC signal terminal 540, the second DC transmission signal terminal 580, the first DC transmission signal terminal 550, and the temperature signal terminal 570, so that the fifth conductive region 150 can transmit control signals through the control signal terminal 560, to control on-off of the third power chip 400.

For example, the semiconductor power module 1 may be further provided with a ninth conductive region 190. The ninth conductive region 190 may be connected to the control signal terminal 560. The seventh conductive region 170 and the eighth conductive region 180 may be connected to the control signal terminal 560 through an aluminum wire, a copper wire, a gold wire, a copper strip, an aluminum strip, a copper connecting piece, or the like, so that the seventh conductive region 170 and the eighth conductive region 180 are controlled, by the control signal terminal 560 of the ninth conductive region 190, to transmit control signals.

According to some specific embodiments of the present disclosure, as shown in FIG. 1 to FIG. 4, the semiconductor power module 1 further includes the first DC transmission terminal 500, the second DC transmission terminal 510, the third DC transmission terminal 520, and the AC transmission terminal 530.

The first DC transmission terminal 500 is connected to the fourth conductive region 140 and extends beyond the edge of the substrate 100, the second DC transmission terminal 510 is connected to the first conductive region 110 and extends beyond the edge of the substrate 100, the third DC transmission terminal 520 is connected to the second conductive region 120 and extends beyond the edge of the substrate 100, and the AC transmission terminal 530 is connected to the third conductive region 130 and extends beyond the edge of the substrate 100.

The first DC transmission terminal 500, the second DC transmission terminal 510, and the third DC transmission terminal 520 are arranged on one of two opposite sides of the substrate 100, and the AC transmission terminal 530 is arranged on the other of the two opposite sides of the substrate 100.

In this way, a connection between the AC and the DC may not interfere with each other, and safety of the electrical connection is improved. Because the first DC transmission terminal 500, the second DC transmission terminal 510, and the third DC transmission terminal 520 are located on the same side of the substrate 100, and a current of the first conductive region 110 is opposite to a current of the first transverse section 142, a magnetic field generated by the first conductive region 110 is opposite to a magnetic field generated by the first transverse section 142, and the two magnetic fields can cancel each other out. A current direction of the second conductive region 120 is opposite to a current direction of the second transverse section 143, and therefore, a magnetic field generated by the second conductive region 120 is opposite to a magnetic field generated by the second transverse section 143, and the two magnetic fields can cancel each other out, thereby reducing a parasitic inductance of the entire semiconductor power module 1 and reducing a switching loss.

According to some specific embodiments of the present disclosure, as shown in FIG. 1, FIG. 2, and FIG. 5, a first high-voltage connection part 111 is disposed on the first conductive region 110, a width of the first high-voltage connection part 111 is greater than a width of a remaining part of the first conductive region 110, and the second DC transmission terminal 510 is connected to the first high-voltage connection part 111. A second high-voltage connection part 121 is disposed on the second conductive region 120, a width of the second high-voltage connection part 121 is greater than a width of a remaining part of the second conductive region 120, and the third DC transmission terminal 520 is connected to the second high-voltage connection part 121.

By arranging the first high-voltage connection part 111, the first conductive region 110 can be connected to the second DC transmission terminal 510, and the second DC transmission terminal 510 does not extend beyond the first high-voltage connection part 111 in the second direction, so that a contact area between the second DC transmission terminal 510 and the first conductive region 110 is increased, thereby ensuring reliability of an electrical connection between the second DC transmission terminal 510 and the first conductive region 110.

By arranging the second high-voltage connection part 121, the second conductive region 120 can be connected to the third DC transmission terminal 520, and the third DC transmission terminal 520 does not extend beyond the second high-voltage connection part 121 in the second direction, so that a contact area between the third DC transmission terminal 520 and the second conductive region 120 is increased, thereby ensuring reliability of an electrical connection between the third DC transmission terminal 520 and the second conductive region 120.

For example, the first high-voltage connection part 111 and the second high-voltage connection part 121 are respectively arranged on two opposite sides of the second vertical section 131 in the first direction. One end of the second vertical section 131 does not exceed a side of the third transverse section 132 that faces away from the fourth transverse section 133, and the second vertical section 131 does not exceed a side of the fourth transverse section 133 that faces away from the third transverse section 132. In this way, the second vertical section 131 can avoid the first high-voltage connection part 111 and the second high-voltage connection part 121, thereby improving space utilization on the substrate 100, and ensuring normal operation of the semiconductor power module 1.

According to some specific embodiments of the present disclosure, as shown in FIG. 1 to FIG. 4, the second DC transmission terminal 510 and the third DC transmission terminal 520 are formed as a whole.

In this way, a multi-point connection is formed between the second DC transmission terminal 510 and the third DC transmission terminal 520 as a whole and the substrate 100, connection strength between the second DC transmission terminal 510 and the third DC transmission terminal 520 as a whole and the substrate 100 is high, and during an application process of the semiconductor power module 11, the semiconductor power module 11 has fewer connection points to the outside, which is convenient for disassembly and assembly.

In addition, the second DC transmission terminal 510 and the third DC transmission terminal 520 overlap with and are spaced apart from the first DC transmission terminal 500 in a thickness direction of the substrate 100. In this way, interference between either of the second DC transmission terminal 510 and the third DC transmission terminal 520 and the first DC transmission terminal 500 can be prevented, thereby ensuring safety of an electrical connection.

According to some specific embodiments of the present disclosure, as shown in FIG. 7, the substrate 100 includes an insulation layer 101, a circuit layer 102, and a heat dissipation layer 103.

The circuit layer 102 is connected to one side of the insulation layer 101 in a thickness direction of the insulation layer 101, the first conductive region 110, the second conductive region 120, the third conductive region 130, and the fourth conductive region 140 are formed on the circuit layer 102, and the heat dissipation layer 103 is connected to the other side of the insulation layer 101 in the thickness direction of the insulation layer 101.

The insulation layer 101 may be made of ceramic, the ceramic, for example, may be aluminum oxide (Al2O3), aluminum nitride (AlN), or silicon nitride (Si3N4). In this way, the insulation layer 101 has a good heat conduction effect, a strong insulation capability, and a stable chemical property, which can not only isolate a connection between the circuit layer 102 and the heat dissipation layer 103, but also provide a heat dissipation channel for the semiconductor power module 1.

The circuit layer 102 may be made of a copper material, and the copper is etched into the first conductive region 110, the second conductive region 120, the third conductive region 130, the fourth conductive region 140, the fifth conductive region 150, the sixth conductive region 160, the seventh conductive region 170, and the eighth conductive region 180. The heat dissipation layer 103 may be made of a copper material, and the first DC transmission terminal 500, the second DC transmission terminal 510, the third DC transmission terminal 520, and the AC transmission terminal 530 may all be made of copper materials. In this way, the circuit layer 102, the heat dissipation layer 103, the first DC transmission terminal 500, the second DC transmission terminal 510, the third DC transmission terminal 520, and the AC transmission terminal 530 all have good conductivity performance and heat dissipation performance, and can be effectively connected to an external device.

According to some specific embodiments of the present disclosure, referring to FIG. 7, the semiconductor power module 1 further includes an insulation layer cover 800. The insulation layer cover 800 is mounted on the substrate 100 and covers the first conductive region 110, the second conductive region 120, the third conductive region 130, the fourth conductive region 140, the fifth conductive region 150, the sixth conductive region 160, the seventh conductive region 170, the eighth conductive region 180, the first power chip 200, the second power chip 300, and the third power chip 400. The insulation layer cover 800 can function as insulating and protecting a device, thereby improving safety of the electrical connection of the semiconductor power module 1.

The motor controller 2 according to an embodiment of the present disclosure is described below with reference to the accompanying drawings. As shown in FIG. 7 and FIG. 8, the motor controller 2 includes a heat dissipation bottom plate 700, a coolant channel 900, and the semiconductor power module 1 according to the foregoing embodiments of the present disclosure. The heat dissipation bottom plate 700 is mounted in the coolant channel 900, and the semiconductor power module 1 is arranged on the heat dissipation bottom plate 700.

For example, there are a plurality of semiconductor power modules 1 arranged on the heat dissipation bottom plate 700 in the first direction, and the plurality of semiconductor power modules 1 may be arranged in parallel. A bottom of each semiconductor power module 1 is welded to the heat dissipation bottom plate 700. The coolant channel 900 may be an open-groove water channel, and the heat dissipation bottom plate 700 is mounted on the open groove of the coolant channel 900, so that a heat dissipation function for the semiconductor power module 1 is implemented. This design process is simple, easy to implement, and convenient to operate.

In this embodiment, based on a uniform structural layout and a good heat dissipation effect of the semiconductor power module 1 provided in the foregoing embodiments, the motor controller 2 may be applied to various coolant channel applications, such as a series coolant channel or a parallel coolant channel, so that application flexibility of the motor controller 2 is improved, and a stray inductance in a loop during application is reduced.

The motor controller 2 according to the embodiment of the present disclosure, by using the semiconductor power module 1 according to the foregoing embodiment of the present disclosure, has advantages such as a small stray inductance, a good heat dissipation effect, and a high power density.

According to some embodiments of the present disclosure, there are a plurality of semiconductor power modules 1 arranged spaced apart on the heat dissipation bottom plate 700.

A vehicle according to an embodiment of the present disclosure is described below with reference to accompanying drawings. The vehicle includes a motor and the motor controller 2 according to the foregoing embodiment of the present disclosure. The motor controller 2 is connected to the motor.

The vehicle according to the embodiment of the present disclosure, by using the motor controller 2 according to the embodiment of the present disclosure, has advantages such as a small stray inductance, a good heat dissipation effect, and a high power density.

Other configurations and operations of the semiconductor power module 1, the motor controller 2, and the vehicle according to the embodiments of the present disclosure are known to those of ordinary skill in the art and will not be described in detail herein.

In the descriptions of this specification, descriptions of the reference terms such as "an embodiment", "some embodiments", "exemplary embodiments", "example", "specific example", or "some examples" mean that the specific features, structures, materials or characteristics described with reference to the embodiment or example are included in at least one embodiment or example of the present disclosure. In this specification, schematic descriptions of the foregoing terms do not necessarily direct to a same embodiment or example.

Although the embodiments of the present disclosure have been shown and described, a person of ordinary skill in the art should understand that various changes, modifications, replacements and variations may be made to the embodiments without departing from the principles and spirit of the present disclosure, and the scope of the present disclosure is as defined by the appended claims and their equivalents.

## Claims

1. A semiconductor power module (1), comprising:
a substrate (100);
a first conductive region (110), a second conductive region (120), a third conductive region (130), and a fourth conductive region (140), the first conductive region (110), the second conductive region (120), the third conductive region (130), and the fourth conductive region (140) being arranged spaced apart on the substrate (100), the first conductive region (110) and the second conductive region (120) being respectively arranged on two opposite sides of the third conductive region (130), the fourth conductive region (140) having a part disposed between the first conductive region (110) and the third conductive region (130), and the fourth conductive region (140) further having with a part disposed between the second conductive region (120) and the third conductive region (130); wherein the first conductive region (110), the second conductive region (120), and the fourth conductive region (140) are configured to transmit DC signals, and the third conductive region (130) is configured to transmit AC signals;
at least one first power chip (200), the first power chip (200) being mounted in the first conductive region (110), and the first power chip (200) being connected to the third conductive region (130);
at least one second power chip (300), the second power chip (300) being mounted in the second conductive region (120), and the second power chip (300) being connected to the third conductive region (130); and
at least one third power chip (400), the third power chip (400) being mounted in the third conductive region (130), and the third power chip (400) is connected to the fourth conductive region (140),
wherein the first power chip (200) and the third power chip (400) are separated by the fourth conductive region (140), and the second power chip (300) and the third power chip (400) are separated by the fourth conductive region (140).

2. The semiconductor power module (1) according to claim 1, wherein the substrate (100) comprises a first direction (A) and a second direction (B) orthogonal to each other;
the first conductive region (110) and the second conductive region (120) extend in the second direction (B), the first conductive region (110) and the second conductive region (120) are respectively arranged on two opposite sides of the third conductive region (130) in the first direction (A), a part of the fourth conductive region (140) is disposed between the first conductive region (110) and the third conductive region (130) in the first direction (A), and a part of the fourth conductive region (140) is further disposed between the second conductive region (120) and the third conductive region (130) in the first direction (A),
wherein the first power chip (200) and the third power chip (400) are separated in the first direction (A) by the fourth conductive region (140), and the second power chip (300) and the third power chip (400) are separated in the first direction (A) by the fourth conductive region (140).

3. The semiconductor power module (1) according to claim 2, wherein the fourth conductive region (140) is around at least a part of the third conductive region (130) and has an open-loop shape.

4. The semiconductor power module (1) according to claim 2 or 3, wherein the fourth conductive region (140) comprises:
a first vertical section (141), the first vertical section (141) extending in the first direction (A), and the first vertical section (141) being located at an end of the third conductive region (130) in the second direction (B);
a first transverse section (142), the first transverse section (142) extending in the second direction (B), the first transverse section (142) being connected to the first vertical section (141), the first transverse section (142) being located between the first conductive region (110) and the third conductive region (130) in the first direction (A), the first power chip (200) and the third power chip (400) being separated by the first transverse section (142) in the first direction (A), and the first transverse section (142) being connected to the third power chip (400); and
a second transverse section (143), the second transverse section (143) extending in the second direction (B), the second transverse section (143) being connected to the first vertical section (141), the second transverse section (143) being located between the second conductive region (120) and the third conductive region (130) in the first direction (A), the second power chip (300) and the third power chip (400) being separated by the second transverse section (143) in the first direction (A), and the second transverse section (143) being connected to the third power chip (400).

5. The semiconductor power module (1) according to any one of claims 1 to 4, wherein the first power chip (200) is connected to the third conductive region (130) by a first connection member (210), the second power chip (300) is connected to the third conductive region (130) by a second connection member (310), and the third power chip (400) is connected to the fourth conductive region (140) by a third connection member (430); and
the first connection member (210), the second connection member (310), and the third connection member (430) extend in the first direction (A).

6. The semiconductor power module (1) according to any one of claims 1 to 5, further comprising:
a fifth conductive region (150), the third conductive region (130) comprising an opening (151), a plurality of third power chips (400) being comprised, the plurality of third power chips (400) being respectively arranged on two opposite sides of the opening (151), the fifth conductive region (150) being arranged on the substrate (100), the fifth conductive region (150) being located in the opening (151), the fifth conductive region (150) being arranged spaced apart from the third conductive region (130), and the fifth conductive region (150) being connected to the plurality of third power chips (400),
wherein the fifth conductive region (150) is configured to transmit control signals.

7. The semiconductor power module (1) according to claim 6, wherein the substrate (100) comprises the first direction (A) and the second direction (B) orthogonal to each other; and
the opening (151) and the fifth conductive region (150) both extend in the second direction (B), and the plurality of third power chips (400) are respectively arranged on two opposite sides of the opening (151) in the first direction (A).

8. The semiconductor power module (1) according to claim 7, wherein the third conductive region (130) comprises:
a third transverse section (132);
a fourth transverse section (133), the fourth transverse section (133) and the third transverse section (132) both extending in the second direction (B), the opening (151) being located between the third transverse section (132) and the fourth transverse section (133), the plurality of third power chips (400) being respectively mounted on the third transverse section (132) and the fourth transverse section (133), the third transverse section (132) being connected to the first power chip (200), and the fourth transverse section (133) being connected to the second power chip (300); and
a second vertical section (131), the second vertical section (131) extending in the first direction (A), the second vertical section (131) being connected to an end of the third transverse section (132) that faces away from the fourth conductive region (140), and the second vertical section (131) being connected to an end of the fourth transverse section (133) that faces away from the fourth conductive region (140).

9. The semiconductor power module (1) according to claim 8, wherein two ends of the second vertical section (131) respectively extend beyond the fourth conductive region (140) in the first direction (A).

10. The semiconductor power module (1) according to any one of claims 6 to 9, wherein a plurality of first resistors (152) are arranged in the fifth conductive region (150), and the plurality of third power chips (400) are connected to the plurality of first resistors (152) in a one-to-one correspondence.

11. The semiconductor power module (1) according to any one of claims 6 to 10, further comprising:
an AC signal terminal (540), the AC signal terminal (540) being mounted in the third conductive region (130) and configured to obtain electrical signals of the third conductive region (130);
a first DC transmission signal terminal (550), the first DC transmission signal terminal (550) being mounted in at least one of the first conductive region (110) or the second conductive region (120), and configured to obtain electrical signals of the at least one of the first conductive region (110) or the second conductive region (120);
a second DC transmission signal terminal (580), the second DC transmission signal terminal (580) being mounted in the fourth conductive region (140) and configured to obtain electrical signals of the fourth conductive region (140); and
a control signal terminal (560), the control signal terminal (560) being mounted in the fifth conductive region (150) and configured to control the fifth conductive region (150) to transmit the control signals.

12. The semiconductor power module (1) according to any one of claims 6 to 11, wherein the third power chip (400) comprises a third power region (4001) and a third control region (4002), the third power region (4001) is connected to the fourth conductive region (140), and the third control region (4002) is connected to the fifth conductive region (150).

13. The semiconductor power module (1) according to any one of claims 1 to 12, further comprising:
a sixth conductive region (160), the sixth conductive region (160) being arranged on the substrate (100), the substrate (100) comprising the first direction (A) and the second direction (B) orthogonal to each other, the sixth conductive region (160) being located on a side of the first conductive region (110) in the second direction (B), the sixth conductive region (160) being arranged spaced apart from the first conductive region (110), the sixth conductive region (160) being located on a side of the third conductive region (130) in the first direction (A), and the sixth conductive region (160) being arranged spaced apart from the third conductive region (130);
a temperature sensor (161), the temperature sensor (161) being mounted in the sixth conductive region (160); and
a temperature signal terminal (570), the temperature signal terminal (570) being mounted in the sixth conductive region (160) and configured to obtain electrical signals of the temperature sensor (161).

14. The semiconductor power module (1) according to any one of claims 1 to 13, further comprising:
a seventh conductive region (170), the seventh conductive region (170) being arranged on the substrate (100), the seventh conductive region (170) being located on a side of the first conductive region (110) that faces away from the fourth conductive region (140), and the first power chip (200) being connected to the seventh conductive region (170); and
an eighth conductive region (180), the eighth conductive region (180) being arranged on the substrate (100), the eighth conductive region (180) being located on a side of the second conductive region (120) that faces away from the fourth conductive region (140), and the second power chip (300) being connected to the eighth conductive region (180),
wherein the seventh conductive region (170) and the eighth conductive region (180) are configured to transmit control signals.

15. The semiconductor power module (1) according to claim 14, wherein a plurality of second resistors (171) are arranged in the seventh conductive region (170), a plurality of first power chips (200) are comprised, and the plurality of first power chips (200) are connected to the plurality of second resistors (171) in a one-to-one correspondence; and
a plurality of third resistors (181) are arranged in the eighth conductive region (180), a plurality of second power chips (300) are comprised, and the plurality of second power chips (300) are connected to the plurality of third resistors (181) in a one-to-one correspondence.

16. The semiconductor power module (1) according to claim 14 or 15, wherein the first power chip (200) comprises a first power region (2001) and a first control region (2002), the first power region (2001) is connected to the third conductive region (130), and the first control region (2002) is connected to the seventh conductive region (170); and
the second power chip (300) comprises a second power region (3001) and a second control region (3002), the second power region (3001) is connected to the third conductive region (130), and the second control region (3002) is connected to the eighth conductive region (180).

17. The semiconductor power module (1) according to any one of claims 1 to 16, further comprising:
a first DC transmission terminal (500), the first DC transmission terminal (500) being connected to the fourth transverse section (140), and the first DC transmission terminal (500) extending beyond an edge of the substrate (100);
a second DC transmission terminal (510), the second DC transmission terminal (510) being connected to the first conductive region (110), and the second DC transmission terminal (510) extending beyond the edge of the substrate (100);
a third DC transmission terminal (520), the third DC transmission terminal (520) being connected to the second conductive region (120), and the third DC transmission terminal (520) extending beyond the edge of the substrate (100); and
an AC transmission terminal (530), the AC transmission terminal (530) being connected to the third conductive region (130), and the AC transmission terminal (530) extending beyond the edge of the substrate (100),
wherein the first DC transmission terminal (500), the second DC transmission terminal (510), and the third DC transmission terminal (520) are arranged on one of two opposite sides of the substrate (100), and the AC transmission terminal (530) is arranged on another of the two opposite sides of the substrate (100).

18. The semiconductor power module (1) according to claim 17, wherein a first high-voltage connection part (111) is disposed in the first conductive region (110), a width of the first high-voltage connection part (111) is greater than a width of a remaining part of the first conductive region (110), and the second DC transmission terminal (510) is connected to the first high-voltage connection part (111); and
the second conductive region (120) has a second high-voltage connection part (121), a width of the second high-voltage connection part (121) is greater than a width of a remaining part of the second conductive region (120), and the third DC transmission terminal (520) is connected to the second high-voltage connection part (121).

19. The semiconductor power module (1) according to claim 17 or 18, wherein the second DC transmission terminal (510) and the third DC transmission terminal (520) are formed as a whole, and the second DC transmission terminal (510) and the third DC transmission terminal are spaced apart from and overlap with the first DC transmission terminal (500) in a thickness direction of the substrate (100).

20. The semiconductor power module (1) according to any one of claims 1 to 19, wherein the substrate (100) comprises:
an insulation layer (101);
a circuit layer (102), the circuit layer (102) being connected to a side of the insulation layer (101) in a thickness direction of the insulation layer (101), and the first conductive region (110). the second conductive region (120), the third conductive region (130), and the fourth conductive region (140) being formed on the circuit layer (102); and
a heat dissipation layer (103), the heat dissipation layer (103) being connected to another side of the insulation layer (101) in the thickness direction of the insulation layer (101).

21. The semiconductor power module (1) according to any one of claims 1 to 20, comprising:
an insulation layer cover (800), the insulation layer cover (800) being mounted on the substrate (100), and the insulation layer cover (800) covering the first conductive region (110), the second conductive region (120), the third conductive region (130), the fourth conductive region (140), the first power chip (200), the second power chip (300), and the third power chip (400).

22. A motor controller (2), comprising:
a heat dissipation bottom plate (700);
a coolant channel (900), the heat dissipation bottom plate (700) being mounted in the coolant channel (900); and
the semiconductor power module (1) according to any one of claims 1 to 21, the semiconductor power module (1) being arranged on the heat dissipation bottom plate (700).

23. The motor controller (2) according to claim 22, wherein a plurality of semiconductor power modules (1) are comprised, and the plurality of semiconductor power modules (1) are arranged spaced apart on the heat dissipation bottom plate (700).

24. A vehicle (1000), comprising:
a motor (1001); and
the motor controller (2) according to claim 22 or 23, the motor controller (2) being connected to the motor (1000).
